## Europäisches Patentamt

## European Patent Office

## Office européen des brevets

(19)

(11) Veröffentlichungsnummer: **0 064 717**
**B1**

(12) **EUROPÄISCHE PATENTSCHRIFT**

(45) Veröffentlichungstag der Patentschrift:
**26.08.87**

(51) Int. Cl.⁴: **H 01 L 29/74**

(21) Anmeldenummer: **82103780.1**

(22) Anmeldetag: **03.05.82**

(54) **Thyristor mit verbessertem Schaltverhalten und Verfahren zu seinem Betrieb.**

(30) Priorität: **08.05.81 DE 3118293**

(43) Veröffentlichungstag der Anmeldung:
**17.11.82 Patentblatt 82/46**

(45) Bekanntmachung des Hinweises auf die Patenterteilung:
**26.08.87 Patentblatt 87/35**

(84) Benannte Vertragsstaaten:
**CH FR GB IT LI SE**

(56) Entgegenhaltungen:
**EP - A - 0 028 797**
**EP - A - 0 028 799**
**DE - A - 2 947 669**

(73) Patentinhaber: **Siemens Aktiengesellschaft Berlin und München, Wittelsbacherplatz 2, D-8000 München 2 (DE)**

(72) Erfinder: **Patalong, Hubert, Dr.,
Kurt-Flöricke-Strasse 18, D-8000 München 60 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Gegenstand der EP-A-0 028 797, die nach Artikel 54 Absatz 3 EPÜ zu berücksichtigen ist, ist ein Thyristor mit einem Halbleiterkörper, der zwischen zwei Grenzflächen in aufeinanderfolgenden Schichten einen von einer Kathode kontaktierten n-Emitter, eine p-Basisschicht, eine n-Basisschicht und einen von einer Anode kontaktierten p-Emitter aufweist, wobei mindestens einer der Emitter aus einer Mehrzahl von Emittergebieten besteht und an der zugehörigen Grenzfläche des Halbleiterkörpers angeordnete, als MIS-Strukturen ausgebildete, steuerbare Emitterkurzschlüsse aufweist, die sich an den Rändern der Emittergebiete befinden und jeweils aus einem mit der Kathode (Anode) verbundenen, ersten Halbleitergebiet eines ersten Leitfähigkeitstyps, einem mit der angrenzenden Basisschicht verbundenen, zweiten Halbleitergebiet des ersten Leitfähigkeitstyps und einem zwischen diesen Halbleitergebieten liegenden Halbleiterbereich des zweiten Leitfähigkeitstyps, der von einer gegenüber dem Halbleiterkörper elektrisch isolierten Gate-Elektrode überdeckt ist, bestehen, wobei ein erster Teil der MIS-Strukturen dem Verarmungstyp und ein zweiter Teil der MIS-Strukturen dem Anreicherungstyp angehören und wobei ein erster gemeinsamer Steueranschluss für die Gate-Elektroden der MIS-Strukturen des einen Typs und ein zweiter gemeinsamer Steueranschluss für die Gate-Elektroden der MIS-Strukturen des anderen Typs vorgesehen sind.

Die MIS-Strukturen des ersten Teils dienen dabei im blockierten Zustand des Thyristors bzw. vor dem Zünden desselben als Stabilisierungskurzschlüsse und werden nur während des Zündvorgangs durch einen ihren Gate-Elektroden zugeführten Spannungsimpuls einer ersten Polarität unwirksam geschaltet, während die MIS-Strukturen des zweiten Teils als Löschkurzschlüsse dienen und lediglich zur Löschung des Thyristors mittels eines ihren Gate-Elektroden zugeführten Spannungsimpulses einer zweiten Polarität wirksam geschaltet werden.

Alternativ hierzu können beim Thyristor nach der EP-A-0 028 797 eine Mehrzahl von als MIS-Strukturen ausgebildeten Emitter-Kurzschlüssen vorgesehen sein, die einheitlich dem Verarmungstyp oder Anreicherungstyp angehören, wobei die Gate-Elektroden eines ersten Teils derselben mit einer Vorspannung beschaltet sind, die Kanäle unterhalb der Gate-Elektroden aufbaut oder bei spannungslosen Gate-Elektroden vorhandene Halbleiterkanäle beseitigt, so dass die Strukturen dieses Teils als Stabilisierungskurzschlüsse (Löschkurzschlüsse) dienen, während die übrigen Emitter-Kurzschlüsse, deren Gate-Elektroden nicht mit einer solchen Vorspannung beschaltet sind, dann Löschkurzschlüsse (Stabilisierungskurzschlüsse) darstellen.

Aus der US-A-3 243 669, vgl. insbesondere Fig. 9, und der DE-A-2 625 917 sind Thyristoren mit als MIS-Strukturen ausgebildeten steuerbaren Emitterkurzschlüssen bekannt, die zum Zwecke eines schnellen Löschens der Thyristoren wirksam geschaltet werden. Aus der DE-A-2 625 917 ist es auch bekannt, diese Emitterkurzschlüsse während des Auftretens eines Zündstromimpulses wirksam zu schalten, um eine Zündung zu verhindern. Eine gemeinsame Anordnung von wenigstens einem steuerbaren Emitterkurzschluss, der nur als Stabilisierungskurzschluss dient, und wenigstens einem weiteren steuerbaren Emitterkurzschluss, der nur als Löschkurzschluss dient, auf einem Thyristor lässt sich hieraus nicht entnehmen.

Schliesslich ist aus der DE-A-2 947 669 ein Thyristor bekannt, bei dem steuerbare Emitterkurzschlüsse in Form von MIS-Strukturen vorgesehen sind, um unerwünschte Zündungen bei hohen dV/dt-Belastungen zu vermeiden. Über eine Verwendung der MIS-Strukturen zum Löschen des Thyristors ist aber hierbei nichts ausgesagt.

Der vorliegenden Erfindung liegt die Aufgabe zugrunde, einen Thyristor der eingangs genannten Art anzugeben, der eine grosse Stabilität besitzt und ein gutes Abschaltverhalten zeigt. Das wird durch eine Ausbildung desselben nach dem Patentanspruch 1 erreicht.

Der hiermit erzielbare Vorteil besteht insbesondere darin, dass mit den steuerbaren Emitterkurzschlüssen Lastströme abgeschaltet werden können, die ein Mehrfaches des Dauergrenzstroms des Thyristors betragen.

Die Figur zeigt einen Thyristor mit einem aus dotiertem Halbleitermaterial, z.B. Silizium, bestehenden Halbleiterkörper, der vier aufeinanderfolgende Schichten abwechselnder Leitungstypen aufweist. Dabei bildet eine Mehrzahl von n-Emittergebieten 1a, 1b, 1c den n-Emitter, eine p-leitende Schicht 2 stellt die p-Basisschicht dar eine n-leitende Schicht 3 wird als die n-Basis bezeichnet und eine p-leitende Schicht 4 als p-Emitter. Der p-Emitter 4 ist mit einer Anode 5 aus leitendem Material, z.B. Aluminium, versehen, die einen Anschluss A hat, während die einzelnen n-Emittergebiete 1a, 1b, 1c ... von Teilen 6a, 6b, 6c ... einer Kathode kontaktiert werden, die mit einem gemeinsamen Anschluss K verbunden sind. Auch die Teile 6a usw. der Kathode bestehen aus elektrisch leitendem Material, z.B. Aluminium.

In das n-Emittergebiet 1a sind p-leitende Gebiete 7 und 8 eingefügt, die sich bis zur Grenzfläche 9 des Halbleiterkörpers erstrecken und in dieser von dem Teil 6a der Kathode kontaktiert werden. Zwischen dem Gebiet 7 und einem Teil 10 der p-Basisschicht 2, der unmittelbar neben dem linken Rand des n-Emittergebiets 1a liegt und bis zur Grenzfläche 9 reicht, befindet sich ein Randbereich 11 des n-Emittergebiets 1a, der von einer auf der Grenzfläche 9 aufgebrachten dünnen isolierenden Schicht 12 überdeckt wird. Auf dieser ist ein Gate 13 aus elektrisch leitendem Material, z.B. Aluminium, vorgesehen, das mit einem Steueranschluss G1 verbunden ist. Das Gebiet 7 stellt ein erstes p-leitendes Halbleitergebiet dar, das zusammen mit dem Teil 10 als zweitem Halbleitergebiet desselben Leitungstyps und dem Randbereich 11 als dazwischen liegendem n-leitenden Halbleiterbereich und ferner mit dem Gate 13 und der Isolierschicht 12 eine MIS-Struktur M1a bildet. Diese gehört dem Verarmungstyp an, so dass sich bei spannungslosem Gate 13 ein p-leitender Kanal 14 in dem Randbereich 11 an der Grenzfläche 9 befindet, der das Teil 10 mit dem Gebiet 7 und über dieses mit dem Teil 6a der Kathode niederohmig verbindet. Damit ergibt sich ein Emitterkurzschluss 10, 14, 7 und 6a zwischen den Teilen 1a und 2.

Der p-Kanal 14 besteht entweder aus einem Inversionskanal, der durch ein an der Grenzfläche 9 bestehendes elektrisches Feld aufgebaut ist, oder aus einem dotierten Kanalgebiet, das durch eine flache p-Dotierung unmittelbar an der Grenzfläche 9 erzeugt worden ist. Führt man dem Steueranschluss G1 eine positive Spannung zu, so wird der p-Kanal 14 unterbrochen und der Emitterkurzschluss aufgehoben.

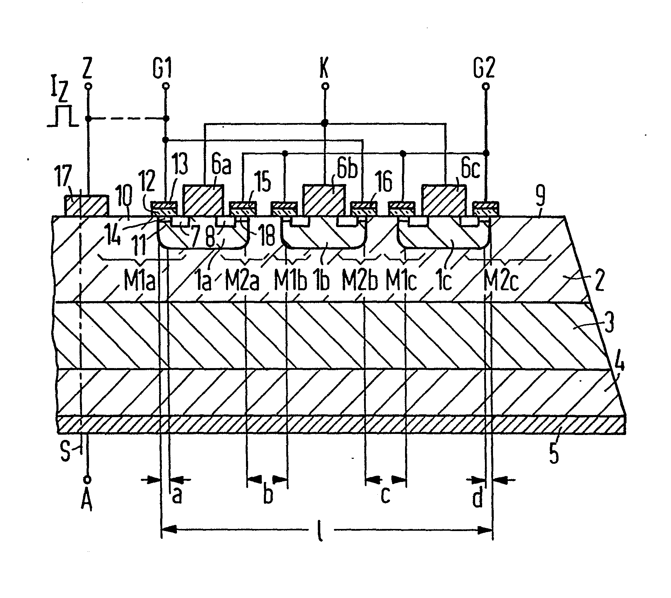

Am rechten Rand des n-Emittergebiets 1a befindet sich eine entsprechend aufgebaute MIS-Struktur M2a. Diese gehört jedoch dem Anreicherungstyp an, wobei ihr Gate 15 mit einem Steueranschluss G2 verbunden ist. Ohne Zuführung einer Spannung an G2 ist in der Struktur M2a kein p-Kanal ausgebildet. Ein solcher in Fig. 1 mit 15 bezeichneter p-Kanal besteht erst bei Zuführung einer negativen Spannung an G2.

Randseitig zu dem n-Emittergebiet 1b sind weitere MIS-Strukturen M1b und M2b vorgesehen und schliesslich an dem n-Emittergebiet 1c entsprechende MIS-Strukturen M1c und M2c. Von diesen ist die Struktur M2b über ihr Gate 16 mit G1 verbunden, während die übrigen Strukturen über ihre Gates an G2 geführt sind. Dabei ist M2b als eine Struktur des Verarmungstyps ausgebildet, während die Strukturen M2a, M1b, M1c und M2c dem Anreicherungstyp angehören.

Auf der p-Basisschicht 2 ist eine Zündelektrode 17 angebracht, die mit dem Anschluss Z eines Zündstromkreises verbunden ist.

Im Betrieb sind die Steueranschlüsse G1 und G2 im blockierten Zustand des Thyristors zunächst von Spannungen freigeschaltet. Dabei ist das n-Emittergebiet 1a wegen des wirksam geschalteten p-Kanals 14 niederohmig mit der p-Basisschicht 2 verbunden, ebenso das n-Emittergebiet 1b über den Kanal der MIS-Struktur M2b. Über die anderen MIS-Strukturen sind keine niederohmigen Verbindungen zwischen den n-Emittergebieten und der p-Basis vorhanden. Die MIS-Strukturen M1a und M2b schalten über ihre Kanäle Stabilisierungskurzschlüsse ein, die unerwünschte Zündvorgänge beim Anliegen von grossen oder schnell ansteigenden Blockierspannungen zwischen A und K vermeiden.

Zur Zündung des Thyristors wird Z ein Zündstromimpuls $I_Z$ zugeführt. Gleichzeitig wird G1 für die Dauer des Zündvorgangs mit einem positiven Impuls beaufschlagt, der die p-Kanäle der Strukturen M1a und M2b unterbricht. Damit sind die Stabilisierungskurzschlüsse für die ganze Dauer des Zündvorgangs unwirksam. Nach erfolgter Zündung fliesst dann ein Laststrom eines bei A und K angeschlossenen Laststromkreises über den niederohmig geschalteten Thyristor.

Soll der Thyristor trotz einer in Durchlassrichtung gepolten Spannung an A und K gelöscht werden, so werden die über M2a, M1b, M1c und M2c verlaufenden Emitterkurzschlüsse wirksam geschaltet, was durch einen negativen Spannungsimpuls am Anschluss G2 erreicht wird. Beim Auftreten dieses Impulses sind dann alle Emitterkurzschlüsse wirksam, so dass der Thyristor schnell gelöscht wird. Die über M2a, M1b, M1c und M2c verlaufenden Emitterkurzschlüsse bezeichnet man auch als Löschkurzschlüsse.

Ein schnelles Löschen des Thyristors auch bei Lastströmen, die ein Mehrfaches seines Dauergrenzstroms betragen, lässt sich erreichen, wenn die während des Löschvorgangs wirksamen Emitterkurzschlüsse mehr als 10%, und zwar bis zu 80% der von der Gesamtheit der n-Emitterzonen 1a bis 1c belegten Querschnittsfläche einnehmen. Das ist der Fall, wenn für die Strecken a bis d und I die Beziehung gilt:

$$\frac{8}{10} \geq (a + b + c + d) : I > \frac{1}{10}$$

Dabei stellt I ein Mass für die gesamte von den Emittergebieten belegte Querschnittsfläche dar. Die Strecken a bis d sind ein Mass für die von allen MIS-Strukturen belegten Flächenanteile.

Die Darstellung in der Figur lässt die tatsächlichen Grössenverhältnisse aus Gründen der Übersichtlichkeit unberücksichtigt.

Die Flächenanteile der zur Stabilisierung dienenden MIS-Strukturen M1a und M2b liegen zweckmässigerweise bei 0,01% bis 3% des von den n-Emittergebieten beanspruchten Teils der Querschnittfläche des Thyristors.

Nach einer Weiterbildung der Erfindung können zusätzlich zu den, oder anstelle der an der Grenzfläche 9 vorgesehenen MIS-Strukturen solche an der gegenüberliegenden Grenzfläche vorgesehen sein, die dann, unter Aufteilung des p-Emitters 4 in einzelne Emittergebiete und unter entsprechender Aufteilung der Anode 5, p-Emitterkurzschlüsse darstellen.

**Patentansprüche**

1. Thyristor mit einem Halbleiterkörper, der zwischen zwei Grenzflächen in aufeinanderfolgenden Schichten einen von einer Kathode (6a, 6b, 6c) kontaktierten n-Emitter (1a, 1b, 1c), eine p-Basisschicht (2), eine n-Basisschicht (3) und einen von einer Anode (5) kontaktierten p-Emitter (4) aufweist, wobei mindestens einer der Emitter aus einer Mehrzahl von Emittergebieten (1a, bis 1c) besteht und an der zugehörigen Grenzfläche (9) des Halbleiterkörpers angeordnete, als MIS-Strukturen ausgebildete, steuerbare Emitterkurzschlüsse (M1a, M2a...) aufweist, die sich an den Rändern der Emittergebiete (1a) befinden und jeweils aus einem mit der Kathode (6a) (Anode) verbundenen, ersten Halbleitergebiet (7) eines ersten Leitfähigkeitstyps, einem mit der angrenzenden Basisschicht (2) verbundenen zweiten Halbleitergebiet (10) des ersten Leitfähigkeitstyps und einem zwischen diesen Halbleitergebieten liegenden Halbleiterbereich (11) des zweiten Leitfähigkeitstyps, der von einer gegenüber dem Halbleiterkörper elektrisch isolierten Gate-Elektrode (13) überdeckt ist, bestehen, wobei ein erster Teil der MIS-Strukturen (M1a, M2b) dem Verarmungstyp und ein zweiter Teil der MIS-Strukturen (M2a, M1b, M1c, M2c) dem Anreicherungstyp angehören und wobei ein erster gemeinsamer Steueranschluss (G1) für die Gate-Elektroden der MIS-Strukturen des einen Typs und ein zweiter gemeinsamer Steueranschluss (G2) für die Gate-Elektroden der MIS-Strukturen des anderen Typs vorgesehen sind, und wobei beide Teile der MIS-Strukturen (M1a, M2a, M1b, M2b, M1c, M2c) zusammengenommen mehr als 10 Prozent, und zwar bis zu 80 Prozent, des von den n(p)-Emittergebieten (1a bis 1c) in ihrer Gesamtheit beanspruchten Teils (I) der Querschnittsfläche des Thyristors einnehmen.

2. Verfahren zum Betrieb eines Thyristors nach Anspruch 1, bei dem dem ersten gemeinsamen Steueranschluss (G1) ein die zugehörigen Emitterkurzschlüsse (M1a, M2b) während des Zündvorgangs aufhebender erster Spannungsimpuls einer ersten Polarität und dem zweiten gemeinsamen Steueranschluss (G2) ein die zugehörigen Emitterkurzschlüsse (M2a, M1b, M1c, M2c) während des Löschvorgangs wirksam schaltender, zweiter Spannungsimpuls der entgegengesetzten Polarität zugeführt werden.

## Claims

1. A thyristor having a semiconductor body which exhibits, in successive layers between two boundary surfaces, an n-emitter (1a, 1b, 1c) contacted by a cathode (6a, 6b, 6c), a p-base layer (2), an n-base layer (3), and a p-emitter (4) which is contacted by an anode (5), wherein at least one of the emitters consists of a plurality of emitter zones (1a to 1c) and has controllable emitter short-circuits (M1a, M2a...) arranged in the form of MIS-structures at the associated boundary surface (9) of the semiconductor body, and which are located at the edges of the emitter zones (1a) and in each case consist of a first semiconductor zone (7) of a first conductivity type connected to the cathode (6a) (anode), a second semiconductor zone (10) of the first conductivity type connected to the adjacent base layer (2), and a semiconductor region (11) of the second conductivity type which is arranged between these semiconductor zones and is covered by a gate electrode (13) which is electrically insulated with respect to the semiconductor body, where a first part of the MIS-structures (M1a, M1b) is of the depletion type and a second part of the MIS-structures (M2a, M1b, M1c, M2c) is of the enhancement type and where a first common control terminal (G1) is provided for the gate electrodes of the MIS-structures of the first type and a second common control terminal (G2) is provided for the gate electrodes of the MIS-structures of the other type, and where both parts of the MIS-structures (M1a, M2a, M1b, M2b, M1c, M2c) together represent more than ten percent and up to eighty percent of that part (I) of the cross-sectional surface of the thyristor occupied by the n(p)-emitter zones (1a to 1c) in their entirety.

2. A method for operating a thyristor as claimed in Claim 1, wherein the first common control terminal (G1) is supplied with a first voltage pulse of a first polarity which cancels the associated emitter short-circuits (M1a, M2b) during the ignition process and the second common control terminal (G2) is supplied with a second voltage pulse of the opposite polarity which activates the associated emitter short-circuits (M2a, M1b, M1c, M2c) during the extinguishing process.

## Revendications

1. Thyristor comportant un corps semiconducteur, qui comprend, entre deux surfaces limites, selon des couches superposées, un émetteur de type n (1a, 1b, 1c) en contact avec une cathode (6a, 6b, 6c), une couche de base de type p (2), une couche de base de type n (3) et un émetteur de type p (4) en contact avec une anode (5), et dans lequel au moins l'un des émetteurs est constitué par une multiplicité de régions d'émetteur (1a, 1c) et comporte des courts-circuits commandables d'émetteur (M1a, M2a...) disposés au niveau de la surface limite associée (9) du corps semiconducteur et réalisés sous la forme de structures MIS et qui sont situés au niveau des bords des régions d'émetteur (1e) et sont constitués chacun par une première région semiconductrice (7) possédant un premier type de conductivité et reliée à la cathode (6a) (anode), par une seconde région semiconductrice (10) possédant le premier type de conductivité et reliée à la couche de base limitrophe (2) et par une zone semiconductrice (11) possédant le second type de conductivité et située entre ces régions semiconductrices et qui est recouverte par une électrode de grille (13) isolée du point de vue électrique par rapport au corps semiconducteur, et dans lequel une première partie des structures MIS (M1a, M2b) est du type à appauvrissement et une seconde partie des structures MIS (M2a, M1b, M1c, M2c) est du type à enrichissement, et dans lequel il est prévu une première borne commune de commande (G1) pour les électrodes de grille des structures MIS d'un type et une seconde borne commune de commande (G2) pour les électrodes de grille des structures MIS de l'autre type, et dans lequel les deux parties des structures MIS (M1a, M2a, M1b, M2c, M1c, M2c) occupent ensemble plus de 10 pour cent, et d'une manière générale jusqu'à 80 pour cent, de la partie (I), occupée par les régions d'émetteur de type n (p) (1a à 1c) dans leur totalité, de la surface en coupe transversale du thyristor.

2. Procédé pour faire fonctionner un thyristor suivant la revendication 1, selon lequel une première impulsion de tension, qui possède une première polarité supprime les courts-circuits associés d'émetteur (M1a, M2b) pendant le processus d'allumage, est appliquée à la première borne commune de commande (G1) et une seconde impulsion de tension, qui possède la polarité opposée et branche à l'état actif les courts-circuits associés d'émetteur (M2a, M1b, M1c, M2c) pendant le processus d'extinction, est appliquée à la seconde borne commune de commande (G2).